# EUROPEAN PATENT SPECIFICATION

(11) **EP 1 403 716 B1**
(45) Date of publication and mention of the grant of the patent: **16.01.2013**
(21) Application number: 03022141.0
(22) Date of filing: 30.09.2003
(51) Int. Cl.: G03F 7/32, G03F 7/40

(54) **Process for developing lithographic printing plate**
Verfahren zum Entwickeln einer lithographischen Druckplatte
Procédé de développement d'une plaque d'impression lithographique

(30) Priority: 30.09.2002 JP 2002286111
(43) Date of publication of application: 31.03.2004
(73) Proprietor: FUJIFILM Corporation, Minato-ku Tokyo (JP)
(72) Inventor: Tsuchiya, Mitsumasa, Haibara-gun Shizuoka (JP); Kawauchi, Ikuo, Haibara-gun Shizuoka (JP)
(74) Representative: HOFFMANN EITLE

(56) References cited:
- EP-A- 0 909 657
- EP-A- 1 147 884
- EP-A- 1 156 371
- EP-A- 1 162 063
- DE-A1- 3 705 896
- JP-A- 62 196 656
- JP-A- 62 215 266
- US-A- 4 837 131

## Description

### Background of the Invention

### 1. Field of the Invention

The present invention relates to a process for the development of a lithographic printing plate. More particularly, the present invention relates to a process for the development of a lithographic printing plate comprising steps of subjecting an infrared laser beam-recording lithographic printing plate precursor (a lithographic printing plate precursor capable of recording with an infrared laser) to exposure to infrared ray and then to development with a developer.

### 2. Description of Related Art

In the work of making lithographic printing plate, an automatic developing machine is widely used for the rationalization of work and the uniformalization of quality of printing plate. An automatic developing machine normally comprises a development portion and a post-processing portion. A lithographic printing plate which has been subjected to exposure or the like to form a latent image therein is subjected to development with a developer made of an alkaline aqueous solution in the development tank in the automatic developing machine, and then subjected to post-processing, including washing with water and processing with a rinsing solution containing a surface active agent and a desensitizer containing gum arabic, starch derivative, etc. At the exposure step, the lithographic printing plate is exposed to light with an energy great enough to make a difference in rate of dissolution in the developer between the non-image area and the image area. At the development step, the aforementioned difference in dissolution rate between the image area and the non-image area is utilized to form an image. In the post-treatment portion, washing with water is effected to remove developer components from the surface of the printing plate.

In recent years, with the development of solid laser/semiconductor laser which emit light in a wavelength ranging from near infrared and infrared, a system utilizing these infrared laser beams has been noted as a system for making plate directly from digital data in computer. As an infrared laser beam-exposable positive-working lithographic printing plate material for direct plate making there has been disclosed an image-forming material comprising an aqueous alkali-soluble resin and a material which absorbs light to generate heat and a positive-working photosensitive compound such as quinonediazide compound incorporated in the resin (see Patent Reference 1 (JP-A-7-285275)). In this image-recording material, the positive-working photosensitive compound acts as a dissolution inhibitor for substantially reducing the solubility of the aqueous alkali-soluble resin at the image area while the positive-working photosensitive compound decomposes when acted on by heat to lose its dissolution inhibiting capacity and become removable upon development. In this manner, an image is formed.

It is also known that an onium salt and an alkali-insoluble hydrogenatable compound act to inhibit the dissolution of an alkali-soluble polymer in an alkali (see Patent Reference 2 (WO97/39894)). Referring to an image-forming material for infrared laser, it is known that a composition comprising a cationic infrared-absorbing dye as a dissolution inhibitor for aqueous alkali-soluble polymer shows a positive-working action. In accordance with this positive-working action, the infrared-absorbing dye absorbs laser beam to generate heat by which the effect of inhibiting the dissolution of the polymer film at the irradiated area is lost to form an image.

It was found that when a positive-working photosensitive lithographic printing plate having an image-recording layer containing such an infrared absorber and a novolak resin that increases its solubility in an alkaline aqueous solution upon exposure to infrared laser beam is subjected to development using the aforementioned automatic developing machine, the developer having the photosensitive layer components dissolved therein is carried over into the rinsing portion, causing the agglomeration of the photosensitive layer components and producing scum.

DE-A-3 705 896 teaches a method for forming a pattern-wise photoresist layer on the surface of a substrate. The method comprises the steps of:
(a) forming a layer of photo-working photoresist composition on the surface of a substrate;
(b) exposing the layer of the positive-working photoresist pattern-wise to actinic rays to increase the solubility of the photoresist composition on the areas exposed to the actinic rays;
(c) dissolving away the layer of the photoresist composition on the areas exposed to the actinic rays with a developer solution to leave a pattern-wise photoresist layer on the surface of the substrate; and
(d) rinsing the substrate with the pattern-wise photoresist layer on the surface thereof with a scum-remover solution which is a mixture of 100 parts by weight of an aqueous solution of from 0.5 to 1.5% by weight of tetramethylammonium hydroxide or trimethyl 2-hydroxymethyl ammonium hydroxide, and from 1 to 30 parts by weight of a water-miscible organic solvent.

### Summary of the Invention

An object of the invention is to solve the aforementioned problems. In other words, an object of the invention is to provide a development process capable of inhibiting the occurrence of development scum during development.

According to the present invention, there is provided a process for developing a lithographic printing plate comprising the steps of:
exposing with infrared rays a lithographic printing plate precursor comprising a photosensitive layer capable of recording with an infrared laser beam, the photosensitive layer comprising an infrared absorber and a novolak resin;
developing the exposed lithographic printing plate precursor with a developer having a pH value of 12.5 to 14.0; and
processing the developed lithographic printing plate precursor with an aqueous solution having a pH value of from 9 to 11 directly after the development step.

Preferably the developer contains an alkali silicate. Preferably the developer contains a non-reducing sugar and a base.

### Detailed Description of the Invention

Embodiments of implementation of the invention will be described in detail hereinafter.

Aqueous solution to be used in processing directly after development:

In the invention, the lithographic printing plate is processed with an aqueous solution having a pH value of from 9 to 11 (for example, at 25°C) directly after development step. When the pH value of the aqueous solution falls below 9, the resulting effect of inhibiting the occurrence of development scum is not sufficient. On the contrary, when the pH value of the aqueous solution exceeds 11, the resulting aqueous solution dissolves the photosensitive layer on the image area to disadvantage from the standpoint of stability of image quality. To process with the aqueous solution directly after development step means to process with the aqueous solution without being exposed to any treatment solution other than the aqueous solution after the development step. It suffices if the pH value of the aqueous solution for processing the lithographic printing plate directly after development step is from 9 to 11. The method for controlling the pH value of the aqueous solution is not specifically limited, but the following method may be employed.

For example, there maybe employed amethodwhich comprises incorporating an alkaline developer as a developer in the subsequent processing tank. In accordance with this method, the adjustment can be achieved by adding an alkaline developer having a pH value of about 13 in a concentration of from 0.01 to 1% to neutral water.

In some detail, during the processing of the lithographic printing plate, the lithographic printing plate with the developer attached to the surface thereof may be received into the subsequent processing tank so that the developer component attached to the surface of the lithographic printing plate is added to the processing tank. Alternatively, a replenishing device equipped with a pump may be used to supply the alkaline developer directly into the subsequent tank. However, the invention is not limited to these methods. Further, an alkaline agent which shows basicity in aqueous solution may be added to the processing tank following the development tank.

The alkaline agent may be properly selected from the group consisting of known alkaline agents. Examples of these alkaline agents include inorganic alkaline agents such as sodium hydroxide, potassium hydroxide, lithium hydroxide, trisodium phosphate, tripotassium phosphate, triammonium phosphate, disodium phosphate, dipotassium phosphate, diammonium phosphate, sodium carbonate, potassium carbonate, ammonium carbonate, sodium hydrogencarbonate, potassium hydrogencarbonate, ammonium hydrogencarbonate, sodium borate, potassium borate and ammonium borate, potassium citrate, tripotassium citrate, and sodium citrate.

Further preferred examples of alkaline agents include organic alkaline agents such as menomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine and pyridine.

These alkaline agents may be used singly or in combination of two or more thereof. Preferred among these alkaline agents are trisodium phosphate, tripotassium phosphate, sodium carbonate and potassium carbonate because they have buffer action themselves and thus can provide an aqueous solution having stable quality.

Alternatively, an organic compound which exhibits buffer action when used in combination with the aforementioned alkaline agent is preferably used from the standpoint of stability of quality. Examples of organic compounds having buffer action include saccharides (particularly those represented by the general formula (I) or (II)), oximes (particularly those represented by the general formula (III), phenols (particularly those represented by the general formula (IV) and fluorinated alcohols (particularly those represented by the general formula (V)) described as compounds having buffer action in JP-A-8-220775. Preferred among the compounds represented by the general formulae (I) to (V) are saccharides represented by the general formula (I) or (II) and phenols represented by the general formula (IV). Particularly preferred among saccharides represented by the general formula (I) or (II) are nonreducing sugars such as saccharose and sulfosalicylic acid. Examples of the nonreducing sugars include trehalose type oligosaccharides having reducing groups connected to each other, glycosides having reducing group in saccharide and nonsaccharides connected to each other, and sugar alcohols obtained by hydrogenating and reducing saccharides. Any of these compounds may be used in the invention.

Examples of the aforementioned trehalose type oligosaccharides include saccharose, and trehalose. Examples of the aforementioned glycosides include alkyl glycoside, phenol glycoside, and mustard oil glycoside. Examples of the aforementioned sugar alcohols include D, L-arabitol, ribitol, xylitol, D, L-sorbitol, D, L-mannitol, D, L-iditol, D, L-talitol, dulcitol, and arodulicitol. Further, maltitol obtained by the hydrogenation of disaccharide or reduced material (reduced starch sirup) obtained by the hydrogenation of oligosaccharide may be used.

Preferred among these nonreducing sugars are sugar alcohols and saccharose. Even more desirable among these nonreducing sugars are D-sorbitol, saccharose, and reduced starch sirup because they have buffer action within a proper pH range. These nonreducing sugars may be used singly or in combination of two or more thereof.

### Developer:

The developer to be used in the invention is an alkaline aqueous solution having a pH of 12.5 to 14.0 at 25°C. As the alkaline aqueous solution there may be properly selected from the group consisting of known alkaline aqueous solutions. For example, a developer including an alkali silicate, or nonreducing sugar and a base may be used. The aforementioned alkali silicate becomes alkaline when dissolved in water. Examples of the alkali silicate include alkaline metal silicates such as sodium silicate, potassium silicate and lithium silicate, and ammonium silicate. These alkali silicates may be used singly or in combination of two or more thereof.

The developing properties of the aforementioned alkaline aqueous solution can be easily adjusted by adjusting the mixing ratio of silicon oxide SiO₂, which is a silicate component, and alkali oxide M₂O (in which M represents an alkaline metal or ammonium group) and the concentration of the alkaline aqueous solution.

Preferred among the aforementioned alkaline aqueous solutions is one comprising silicon oxide SiO₂ and alkali oxide M₂O at a mixing molar ratio (SiO₂/M₂O) of from 0.5 to 3.0, more preferably from 1.0 to 2.0.

When SiO₂/M₂O ratio falls below 0.5, the resulting alkaline aqueous solution exhibits a raised alkaline strength, occasionally causing a trouble that a general-purpose aluminum sheet or the like is etched. On the contrary, when SiO₂/M₂O ratio exceeds 3.0, the resulting alkaline aqueous solution occasionally exhibits deteriorated developing properties.

The concentration of alkali silicate in the developer is preferably from 1 to 10% by weight, more preferably from 3 to 8% by weight, most preferably from 4 to 7% by weight based on the weight of the alkaline aqueous solution. When the concentration of alkali silicate falls below 1% by weight, the resulting developer can exhibit deteriorated developing properties and processing properties. On the contrary, when the concentration of alkali silicate exceeds 10% by weight, the resulting developer can easily undergo precipitation or crystallization and even gelation when neutralized during discharge, causing trouble in discharge.

Referring to the developer made of nonreducing sugar and base, the term "nonreducing sugar" means a saccharide which is free of free aldehyde or ketone group and thus is not reducing. Nonreducing sugars can be classified into trehalose type oligosaccharides having reducing groups connected to each other, glycosides having reducing group in saccharide and nonsaccharides connected to each other and sugar alcohols obtained by hydrogenating and reducing saccharides. In the invention, any of these nonreducing sugars can be used to advantage.

Examples of the trehalose type oligosaccharides include saccharose, and trehalose. Examples of the glycosides include alkyl glycoside, phenol glycoside, and mustard oil glycoside.

Examples of the sugar alcohols include D, L-arabitol, ribitol, xylitol, D,L-sorbitol, D,L-mannitol, D,L-iditol, D,L-talitol, dulcitol, and arodulicitol. Further, maltitol obtained by the hydrogenation of disaccharide or reduced material (reduced starch sirup) obtained by the hydrogenation of oligosaccharide may be used.

Preferred among these nonreducing sugars are sugar alcohols and saccharose. Even more desirable among these nonreducing sugars are D-sorbitol, saccharose, and reduced starch sirup because they have buffer action within a proper pH range.

These nonreducing sugars may be used singly or in combination of two or more thereof. The proportion of these nonreducing sugars in the developer is preferably from 0.1 to 30% by weight, more preferably from 1 to 20% by weight.

The aforementioned alkali silicate or nonreducing sugar may be used in combination with an alkaline agent, as a base, properly selected from the group consisting of known materials.

Examples of the alkaline agent include inorganic alkaline agents such as sodium hydroxide, potassium hydroxide, lithium hydroxide, trisodium phosphate, tripotassium phosphate, triammonium phosphate, disodium phosphate, dipotassium phosphate, diammonium phosphate, sodium carbonate, potassium carbonate, ammonium carbonate, sodium hydrogencarbonate, potassium hydrogencarbonate, ammonium hydrogencarbonate, sodium borate, potassium borate and ammonium borate, potassium citrate, tripotassium citrate, and sodium citrate.

Further preferred examples of alkaline agents include organic alkaline agents such as menomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine and pyridine.

These alkaline agents may be used singly or in combination of two or more thereof.

Preferred among these alkaline agents are sodium hydroxide and potassium hydroxide. This is because when the amount of these alkaline agents based on the weight of nonreducing sugar is properly adjusted, the pH value of the developer can be adjusted over a wide range. Also preferred are trisodium phosphate, tripotassium phosphate, sodium carbonate and potassium carbonate because they have buffer action themselves.

As the alkaline developer there is used a developer containing an alkali silicate or nonreducing sugar or a base as mentioned above. As the cationic components to be incorporated in the developer there has been heretofore used Li⁺, Na⁺, K⁺ and NH₄⁺. A developer system containing much cations having an ionic radius has a high penetrating power and hence good developing properties but dissolves the lithographic printing plate even at the image area to cause image defectives. Accordingly, there is some upper limit of the concentration of alkali. In order to process the lithographic printing plate completely without causing any defects in image area and leaving the photosensitive layer behind on the non-image area (film residue), it is required that close liquid conditions be predetermined.

However, by using as the aforementioned cationic components cations having a great ionic radius, the penetration of the developer into the photosensitive layer can be inhibited, making it possible to enhance the effect of inhibiting the dissolution of the image area without deteriorating the concentration of alkali, i.e., developing properties.

As the aforementioned cationic components there may be used other cations besides the aforementioned alkaline metal cations and ammonium ions.

The alkaline developer may further comprise the following additives incorporated therein for the purpose of further enhancing the developing properties.

Examples of these additives include neutral salts such as NaCl, KCl and KBr as disclosed in JP-A-58-75152, chelating agents such as EDTA and NTA as disclosed in JP-A-58-190952, complexes such as [Co(NH₃)₆]Cl₃ and CoCl₂·6H₂O as disclosed in JP-A-59-121336, anionic or amphoteric surface active agents such as sodium alkylnaphthalenesulfonate and n-tetradecyl-N,N-dihydroxyethylbetaine as disclosed in JP-A-50-51324, nonionic surface active agents such as tetramethyldecyne diol as disclosed in US Patent 4,374,920, cationic polymers such as methyl chloride quaternary compound of p-dimethylaminomethyl polystyrene as disclosed in JP-A-55-95946, amphoteric polymer electrolytes such as copolymer of vinylbenzyl trimethyl ammonium chloride with sodium acrylate as disclosed in JP-A-56-142528, reducing inorganic salts such as sodium sulfite as disclosed in JP-A-57-192951, inorganic lithium compounds such as lithium chloride as disclosed in JP-A-58-59444, organic metallic surface active agents containing organic silicon and titanium compounds as disclosed in JP-A-59-75255, organic boron compounds as disclosed in JP-A-59-84241, and quaternary ammonium salts such as tetraalkylammonium oxide as disclosed in EP101010.

The manner in which the alkaline developer is used is not specifically limited.

In recent years, an automatic developing machine for printingplatematerial has been widely used for rationalization and standardization of plate making job particularly in the art of plate making and printing.

This automatic developing machine normally comprises a developing portion and a post-treatment portion, i.e., device for conveying the printing plate material, various processing solution tanks and a spray device. In operation, various processing solutions which have been pumped up are sprayed onto the exposed printing plate through spray nozzles while being conveyed horizontally. Further, a method has been recently known which comprises conveying the printing plate material into a processing tank filled with a processing solution over submerged guide rollers so that it is processed. During such an automatic processing, the various processing solutions may be replenished with its replenisher depending on the amount processed, working time, etc.

In this case, by adding to the developer an aqueous solution having a higher alkali concentration than the developer as a replenisher, a large amount of image-forming material can be processed in the development tank over an extended period of time without replacing the developer. A preferred embodiment of the plate making process of the invention involves the employment of this replenishment process also when the aforementioned alkaline developer is used.

As the aforementioned replenisher there may be used the foregoing alkaline developer in the form of aqueous solution having a higher alkaline strength than the developer for development.

The aforementioned developer and its replenisher may comprise various surface active agents or organic solvents other than mentioned above incorporated therein as necessary for the purpose of accelerating or inhibiting its developing properties, dispersing development scum and enhancing the ink-receptivity of the image area on the printing plate.

The surface active agents may be selected from the group consisting of nonionic, anionic, cationic and amphoteric surface active agents. As the organic solvents there are preferably used benzyl alcohol, etc. Alternatively, a polyethylene glycol or its derivative, or polypropylene glycol or its derivative may be added.

Further, if necessary, an inorganic salt-based reducing agent such as hydroquinone, resorcin and sodium or potassium salt of sulfurous acid or hydrogensulfurous acid, an organic carboxylic acid, an anti-foaming agent and a water softener may be added.

The lithographic printing plate which has been subjected to development with an alkaline developer and its replenisher is processed with the aforementioned rinsing water, which is one of the characteristics of the invention, and then subjected to post-treatment with a known rinsing solution containing a surface active agent or the like and a desensitizer containing gum arabic and a starch derivative.

The photosensitive layer of the lithographic printing plate precursor to be used in the invention will be described hereinafter.

Polymer compound which is insoluble in water but soluble in an alkaline aqueous solution:

The photosensitive layer of the lithographic printing plate precursor to be used in the invention comprises a novolak resin incorporated therein as a polymer compound which is insoluble in water but soluble in an alkaline aqueous solution. This novolak resin is preferably a polycondensate of phenol with aldehyde, particularly a polycondensate of phenol with formaldehyde. Specific examples of such a polycondensate include polycondensate of phenol with formaldehyde (hereinafter referred to as "phenol-formaldehyde resin"), polycondensate of m-cresol with formaldehyde (hereinafter referred to as "m-cresol-formaldehyde resin"), polycondensate of p-cresol with formaldehyde, polycondensate of m-/p- mixed cresol with formaldehyde, and polycondensate of phenol and cresol (m-, p- or m-/p- mixed cresol).

The photosensitive layer of the lithographic printing plate precursor to be used in the invention may comprise other polymer compounds which are insoluble in water but soluble in an alkaline aqueous solution besides the aforementioned novolak resins. The term "polymer compound which is insoluble in water but soluble in an alkaline aqueous solution" as used herein is meant to indicate a polymer compound having the following acid group structure in its main or side chains. Examples of the acid group structure include phenolic hydroxyl group (-Ar-OH), carboxylic acid group (-CO₂H), sulfonic acid group (-SO₃H), phosphoric acid group (-OPO₃H), sulfonamide group (-SO₂NH-R), and substituted sulfonamide-based acid group (active imide group) (-SO₂NHCOR, -SO₂NHSO₂R, -CONHSO₂R) in which Ar represents a divalent aryl group which may have substituents and R represents a hydrocarbon group which may have substituents. Preferred among these acid groups are (a-1) phenolic hydroxyl group, (a-2) sulfonamide group, and (a-3) active imide group, particularly (a-1) aqueous alkali-soluble resin having phenolic hydroxyl group (hereinafter referred to as "resin having phenolic hydroxyl group").

As the polymer compound having phenolic hydroxyl group (a-1) other than novolak resin there may be used a polycondensate of pyrogallol with acetone. Alternatively, a copolymer obtained by the copolymerization of monomers having phenol group in its side chain may be used. Examples of the monomer having phenolic group employable herein include acrylamide having phenol group, methacrylamide having phenol group, acrylic acid ester having phenol group, methacrylic acid ester having phenol group, and hydroxystyrene. Specific examples of these monomers include N-(2-hydroxyphenyl)acrylamide, N-(3-hydroxyphenyl)acrylamide, N-(4-hydroxyphenyl)acrylamide, N-(2-hydroxyphenyl)methacrylamide, N-(3-hydroxyphenyl)methacrylamide, N-(4-hydroxyphenyl) methacrylamide, o-hydroxyphenyl acrylate, m-hydroxyphenyl acrylate, p-hydroxyphenyl acrylate, o-hydroxyphenyl methacrylate, m-hydroxyphenyl methacrylate, p-hydroxyphenyl methacrylate, o-hydroxystyrene, m-hydroxystyrene, p-hydroxystyrene, 2-(2-hydroxyphenyl)ethylacrylate, 2-(3-hydroxyphenyl)ethylacrylate, 2-(4-hydroxyphenyl)ethylacrylate, 2-(2-hydroxyphenyl)ethylmethacrylate, 2-(3-hydroxyphenyl)ethyl methacrylate, 2-(4-hydroxyphenyl)ethylmethacrylate, 2-(N'-(4-hydroxyphenyl)ureido)ethylacrylate, and 2-(N'-(4-hydroxyphenyl)ureido)ethylacrylate. The molecular weight of the polymer is preferably from 5.0 x 10² to 2. 0 x 10⁵ as calculated in terms of weight-average molecular weight or from 2.0 x 10² to 1.0 x 10² as calculated in terms of number-average molecular weight from the standpoint of image-forming properties. These resins may be used singly or in combination of two or more thereof. Examples of the resins, if used in combination, include polycondensate of t-butylphenol with formaldehyde and polycondensate of phenol having a C₃-C₈ alkyl group as substituent with formaldehyde such as polycondensate of octyl phenol with formaldehyde as disclosed in US Patent 4,123,279. Further, as disclosed in US Patent 4, 123, 279, a polycondensate of phenol having a C₃-C₈ alkyl group as substituent with formaldehyde such as t-butylphenol-formaldehyde resin and octyl phenol-formaldehyde resin may be additionally used. These resins having phenolic hydroxyl group may be used singly or in combination of two or more thereof.

In the case where the aqueous alkali-soluble polymer compound having sulfonamide group (a-2) is used, the monomer having sulfonamide group (a-2) which is a main monomer constituting the polymer compound may be a monomer made of a lowmolecular compound comprising at least one sulfonamide group having at least one hydrogen atom connected to nitrogen atom per molecule and at least one polymerizable unsaturated bond. Preferred among these monomers are low molecular compounds having acryloyl group, allyl group or vinyloxy group and a substituted or mono-substituted aminosulfonyl group or substituted sulfonylimino group. Examples of these compounds include those represented by the following general formulae 1 to 5. 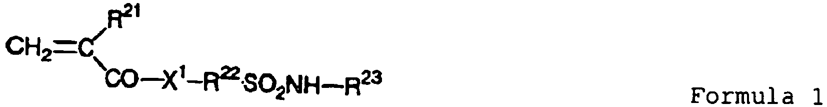 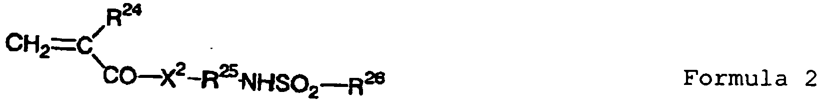 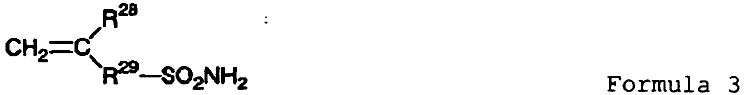 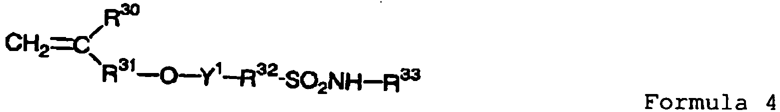 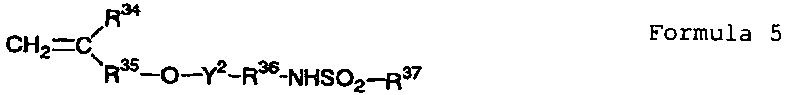 wherein X¹ and X² each represent -O- or -NR¹⁷-; R²¹ and R²⁴ each represent a hydrogen atom or -CH₃; R²², R²⁵, R²⁹, R³² and R³⁶ each represent a C₁-C₁₂ alkylene, cycloalkylene, arylene or aralkylene group, which may have substituents; R²³, R¹⁷ and R³³ each represent a hydrogen atom or a C₁-C₁₂ alkyl, cycloalkyl, aryl or aralkyl group, which may have substituents; R²⁶ and R³⁷ each represent a C₁-C₁₂ alkyl, cycloalkyl, aryl or aralkyl group, which may have substituents; R²⁸, R³⁰ and R³⁴ each represent a hydrogen atom or -CH₃; R³¹ and R³⁵ each represent a single bond or a C₁-C₁₂ alkylene, cycloalkylene, arylene or aralkylene group, which may have substituents; and Y¹ and Y² each represent a single bond or -CO-.

In some detail, m-aminosulfonylphenyl methacrylate, N-(p-aminosulfonylphenyl)methacrylamide, N-(p-aminosulfonylphenyl) acrylamide, etc. can be used to advantage.

The aqueous alkali-soluble polymer compound having active imide group (a-3), if used, has an active imide group represented by the following general formula in its molecule. As the monomer having an active imide group (a-3) which is a main monomer constituting the polymer compound there may be used a monomer made of a low molecular compound having one or more active imino groups represented by the following general formula and one or more polymerizable unsaturated bond.

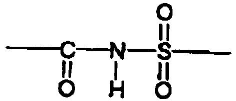

Specific examples of such a compound employable herein include N-(p-toluenesulfonyl)methacrylamide and N-(p-toluenesulfonyl) acrylamide.

The number of kinds of the monomers containing acid groups (a-1) to (a-3) to be incorporated in the aqueous alkali-soluble copolymer employable herein is not necessarily one. A copolymer of two or more monomers having the same acid group or two or more monomers having different acid groups may be used. As the copolymerization method there may be used any known method such as graft copolymerization method, block copolymerization method and random copolymerization method.

The aforementioned copolymer preferably comprises copolymerizable monomers having acid groups (a-1) to (a-3) as copolymerizing components in an amount of not smaller than 10 mol-%, more preferably not smaller than 20 mol-%. When the amount of the copolymerizing components falls below 10 mol-%, the resulting interaction with the resin having phenolic hydroxyl group is insufficient, causing the deterioration of the effect of enhancing development latitude, which is one of the advantages of the use of copolymerizing components.

The copolymer may comprise copolymerizing components other than the aforementioned monomers having acid groups (a-1) to (a-3). Examples of the monomers to be used as copolymerizing components include the following monomers (1) to (12).
(1) Acrylic acid esters and methacrylic acid esters having aliphatic hydroxyl group such as 2-hydroxyethyl acrylate and 2-hydroxyethyl methacrylate;
(2) Alkyl acrylates such as methyl acrylate, ethyl acrylate, propyl acrylate, butyl acrylate, amyl acrylate, hexyl acrylate, octyl acrylate, benzyl acrylate, 2-chloroethyl acrylate, glycidyl acrylate and N-dimethylaminoethyl acrylate;
(3) Alkyl methacrylates such as methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate, glycidyl methacrylate and N-dimethylaminoethyl methacrylate;
(4) Acrylamides or methacrylamides such as acrylamide, methacrylamide, N-methylol acrylamide, N-ethyl acrylamide, N-hexyl methacrylamide, N-cyclohexyl acrylamide, N-hydroxyethylacrylamide, N-phenylacrylamide, N-nitrophenyl acrylamide and N-ethyl-N-phenyl acrylamide;
(5) Vinyl ethers such as ethyl vinyl ether, 2-chloroethyl vinyl ether, hydroxyethyl vinyl ether, propyl vinyl ether, butyl vinyl ether, octyl vinyl ether and phenyl vinyl ether;
(6) Vinyl esters such as vinyl acetate, vinyl chloroacetate, vinyl butyrate and vinyl benzoate;
(7) Styrenes such as styrene, α-methylstyrene, methylstyrene and chloromethylstyrene;
(8) Vinyl ketones such as methyl vinyl ketone, ethyl vinyl ketone, propyl vinyl ketone and phenyl vinyl ketone;
(9) Olefins such as ethylene, propylene, isobutylene, butadiene and isoprene;
(10) N-vinylpyrrolidone, N-vinylcarbazole, 4-vinylprydine, acrylonitrile and methacrylonitrile;
(11) Unsaturated imides such as maleimide, N-acryloylacrylamide, N-acetyl methacrylamide, N-propionyl methacrylamide and N-(p-chlorobenzoyl)methacrylamide; and
(12) Unsaturated carboxylic acids such as acrylic acid, methacrylic acid, maleic anhydride and itaconic acid

In the invention, the aqueous alkali-soluble polymer compound preferably has a molecular weight of not smaller than 2, 000 as calculated in terms of weight-average molecular weight or not smaller than 500 as calculated in terms of number-average molecular weight regardless of which it is homopolymer or copolymer from the standpoint of film strength. More preferably, the aqueous alkali-soluble polymer compound has a molecular weight of from 5,000 to 300,000 as calculated in terms of weight-average molecular weight or from 800 to 250,000 as calculated in terms of number-average molecular weight and a dispersibility (weight-average molecular weight/number-average molecular weight) of from 1.1 to 10.

In the aforementioned copolymer, the mixing weight ratio of the monomers having acid groups (a-1) to (a-3) to the other monomers is preferably from 50 : 50 to 5 : 95, more preferably from 40 : 60 to 10 : 90 from the standpoint of development latitude.

Preferred examples of the polymer compound having phenolic hydroxyl group employable herein include novolak resins such as polycondensate of m-/p- mixed cresol with formaldehyde and polycondensate of phenol and cresol with formaldehyde, N-(4-hydroxyphenyl)methacrylamide/methyl methacrylate/acrylonitrile copolymer, and 2-(N'-(4-hydroxyphenyl)ureido)ethyl methacrylate/methyl methacrylate/acrylonitrile copolymer. Preferred examples of the polymer compound having sulfonamide group employable herein include N-(p-aminosulfonylphenyl)methacrylamide /methyl methacrylate/acrylonitrile copolymer. Preferred examples of the polymer compound having active imide group include N-(p-toluenesulfonyl)methacrylamide/methyl methacrylate/acrylonitrile /2-hydroxyethyl methacrylate copolymer.

These aqueous alkali-soluble polymer compounds may be used singly or in combination of two or more thereof in an amount of from 30 to 99% by weight, preferably from 40 to 95% by weight, particularly from 50 to 90% by weight based on the solid content of the components constituting the photosensitive layer. When the amount of the aqueous alkali-soluble polymer compound to be incorporated falls below 30% by weight, the resulting photosensitive layer exhibits a deteriorated durability. On the contrary, when the amount of the aqueous alkali-soluble polymer compound to be incorporated exceeds 99% by weight, it is disadvantageous in both sensitivity and durability. Infrared absorber:

As previously mentioned, the lithographic printing plate precursor of the invention can be subjected to heat mode exposure. From the standpoint of enhancement of sensitivity to exposure, the lithographic printing plate precursor of the invention preferably comprises an infrared absorber incorporated in the photosensitive layer. In the invention, as the infrared absorber to be optionally incorporated in the photosensitive layer there may be used any material which has a photo-heat conversion function of generating heat when irradiated with infrared laser beam. From the standpoint of effectiveness, the infrared absorber is preferably a dye or pigment having a maximum absorption at a wavelength of from 760 nm to 1,200 nm. From the standpoint of image-forming properties, the infrared absorber is preferably a dye in particular.

As the pigments there may be used commercially available pigments and those described in Handbook of Color Index (C. I.), "Saishin Ganryo Binran (Handbook of Modern Pigments)", Japan Association of Pigment Technology, 1977, "Saishin Ganryo Ouyou Gijutsu (Modern Technology of Application of Pigments)", CMC, 1986, and "Insatsu Inki Gijutsu (Printing Ink Technology)", CMC, 1984.

Examples of the pigments employable herein include black pigment, yellow pigment, orange pigment, brown pigment, red pigment, purple pigment, blue pigment, green pigment, fluorescent pigment, metal powder pigment, and polymer-coupled dye. Specific examples of these pigments include insoluble azo pigment, azo lake pigment, condensed azo pigment, chelate azo pigment, phthalocyanine-based pigment, anthraquinone-based pigment, perylene-based pigment, perynone-based pigment, thioindigo-based pigment, quinacridone-based pigment, dioxazine-based pigment, isoindolinone-based pigment, quinophthalone-based pigment, dyed lake pigment, azine pigment, nitroso pigment, nitro pigment, natural pigment, fluorescent pigment, inorganic pigment, and carbon black.

These pigments may be used untreated or may be subjected to surface treatment before use. Possible examples of the surface treatment methods include method involving the coating of the pigment with a resin or wax, method involving the attachment of a surface active agent to the pigment, and method involving the bonding of a reactive material (e.g., silane coupling agent, epoxy compound, polyisocyanate) to the surface of the pigment. For the details of these surface treatment methods, reference can be made to "Kinzoku Sekken no Seishitsu to Ouyou (Properties and Application of Metal Soap)", Saiwai Shobo, "Insatsu Inki Gijutsu (Printing Ink Technology)", CMC, 1984, and "Saishin Ganryo Ouyou Gijutsu (Modern Technology of Application of Pigments)", CMC, 1986.

The particle diameter of these pigments is preferably from 0.01 µm to 10 µm, more preferably from 0.05 µm to 1 µm, particularly from 0.1 µm to 1 µm. When the particle diameter of these pigments falls below 0.01 µm, it is disadvantageous in the stability of the dispersed material in the photosensitive layer coating solution. On the contrary, when the particle diameter of these pigments exceeds 10 µm, it is disadvantageous in the uniformity of the photosensitive layer. As a method for dispersing the pigment there may be used a known dispersion technique for use in the production of ink, toner, etc. Examples of the dispersing machine employable herein include ultrasonic disperser, sandmill, attritor, pearl mill, supermill, ball mill, impeller, disperser, KD mill, colloid mill, dynatron, three-roll mill, and pressure kneader. For the details of these dispersing machines, reference can be made to "Saishin Ganryo Ouyou Gijutsu (Modern Technology of Application of Pigments)", CMC, 1986.

As the dyes there may be used commercially available dyes and known dyes disclosed in references (e.g., "Senryo Binran (Handbook of Dyes)", The Society of Synthetic Organic Chemistry, Japan, 1970. Specific examples of these dyes include azo dye, metal complex azo dye, pyrazolone azo dye, anthraquinone dye, phthalocyanine dye, carbonium dye, quinonimine dye, methine dye, cyanine dye, diimonium dye, and aminium dye.

Particularly preferred among these pigments or dyes are those absorbing infrared rays or near infrared rays because they are suitable for use with laser emitting infrared rays or near infrared rays.

As the pigment which absorbs infrared rays or near infrared rays there is preferably used carbon black. Examples of the dye which infrared rays or near infrared rays include cyanine dyes disclosed in JP-A-58-125246, JP-A-59-84356, JP-A-59-202829 and JP-A-60-78787, methine dyes disclosed in JP-A-58-173696, JP-A-58-181690 and JP-A-58-194595, naphthoquinone dyes disclosed in JP-A-58-112793, JP-A-58-224793, JP-A-59-48187, JP-A-59-73996, JP-A-60-52940 and JP-A-60-63744, squalelium dyes disclosed in JP-A-58-112792, cyanine dyes disclosed in British Patent 434,875, and dihydroperymidine squalelium dyes disclosed in US Patent 5,380,635.

Further, as the dye there is preferably used a near infrared absorption sensitizer disclosed in US Patent 5,156,938. Further examples of the dye employable herein include substituted arylbenzo(thio)pyrilium salts disclosed in US Patent 3,881,924, trimethine thiapyrilium salts disclosed in JP-A-57-142645 (corresponding to US Patent 4,327,169), pyrilium-based compounds disclosed in JP-A-58-181051, JP-A-58-220143, JP-A-59-41363, JP-A-59-84248, JP-A-59-84249, JP-A-59-146063, and JP-A-59-146061, cyanine dyes disclosed in JP-A-59-216146, pentamethine thiopyrilium salts disclosed in US Patent 4,283,475, and pyrilium compounds disclosed in JP-B-5-13514 and JP-B-5-19702. Particularly preferred examples of the commercially available dyes employable herein include Epolight 111-178, Epolight 111-130, Epolight 111-125 and Epolight IV-62A, produced by EPOLIN, INC.

A particularly preferred example of the dye employable herein is a cyanine dye represented by the general formula 6.

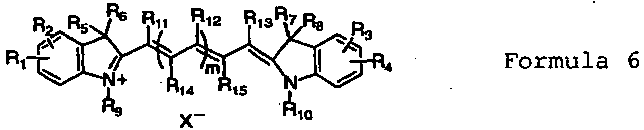

The aforementioned compound has an absorption in an infrared range of from 700 nm to 1,200 nm, exhibits a good compatibility with the aqueous alkali-soluble polymer compound, is a basic dye and has a group that interacts with an aqueous alkali-soluble polymer compound such as ammonium group and iminium group in its molecule. Thus, the aforementioned compound can interact with the polymer compound to control the aqueous alkali solubility thereof. Accordingly, the aforementioned compound can be used in the invention.

In the general formula 6, R¹ to R⁴ each independently represent a hydrogen atom or a C₁-C₁₂ alkyl, alkenyl, alkoxy, cycloalkyl or aryl group which may have substituents. R¹ and R² and R³ and R⁴ each may be connected to each other to form a cyclic structure. Specific examples of the groups represented by R¹ to R⁴ include hydrogen atom, methyl group, ethyl group, phenyl group, dodecyl group, naphthyl group, vinyl group, allyl group, and cyclohexyl group. Examples of the substituents, if any on these groups, include halogen atom, carbonyl group, nitro group, nitrile group, sulfonyl group, carboxyl group, carboxylic acid ester, and sulfonic acid ester. R⁵ to R¹⁰ each independently represent a C₁-C₁₂ alkyl group which may have substituents. Specific examples of the groups represented by R⁵ to R¹⁰ include methyl group, ethyl group, phenyl group, dodecyl group, naphthyl group, vinyl group, allyl group, and cyclohexyl group. Examples of the substituents, if any on these groups, include halogen atom, carbonyl group, nitro group, nitrile group, sulfonyl group, carboxyl group, carboxylic acid ester, and sulfonic acid ester.

The suffix m represents an integer of from 1 to 8, preferably from 1 to 3.

R¹¹ to R¹³ each independently represent a hydrogen atom, a halogen atom or a C₁-C₈ alkyl group which may have substituents. R¹² may be connected to R¹¹ or R¹³ to form a cyclic structure. When m is greater than 2, the plurality of R¹²'s may be connected to each other to form a cyclic structure. Specific examples of the groups represented by R¹¹ to R¹³ include chlorine atom, cyclohexyl group, and cyclopentyl ring and cyclohexyl ring obtained by the connection of R^{12,} s to each other. Examples of the substituents, if any on these groups, include halogen atom, carbonyl group, nitro group, nitrile group, sulfonyl group, carboxyl group, carboxylic acid ester, and sulfonic acid ester.

R¹⁴ and R¹⁵ each independently represent a hydrogen atom, a halogen atom or a C₁-C₈ alkyl group which may have substituents . R¹⁴ and R¹⁵ may be connected to each other to form a cyclic structure. When m is greater than 2, the plurality of R¹⁴, s may be connected to each other to form a cyclic structure. Specific examples of the groups represented by R¹⁴ and R¹⁵ include chlorine atom, cyclohexyl group, and cyclopentyl ring and cyclohexyl ring obtained by the connection of R¹⁴' s to each other. Examples of the substituents, if any on these groups, include halogen atom, carbonyl group, nitro group, nitrile group, sulfonyl group, carboxyl group, carboxylic acid ester, and sulfonic acid ester.

In the general formula 6, X- represents a counter anion. Specific examples of the anion represented by X- include perchloric acid, tetrafluoroboric acid, hexafluorophosphoric acid, triisopropylnaphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3-chlorobenzenesulfonic acid, 3-bromobenzenesulfonic acid, 2-fluorocaprylnaphthalenesulfonic acid, dodecylbenzenesulfonic acid, 1-naphthol-5-sulfonic acid, 2-methoxy-4-hydroxy-5-benzoyl-benzenesulfonic acid, and paratoluenesulfonic acid. Particularly preferred among these anions are hexafluorophosphoric acid, alkylaromatic sulfonic acid such as triisopropylnaphthalenesulfonic acid and 2,5-dimethylbenzenesulfonic acid. When anionic substituents are on R¹ to R¹⁵, X- may not be present.

These infrared absorbers may be incorporated in an amount of from 0.01 to 50% by weight, preferably from 0.1 to 20% by weight, more preferably from 0.5 to 15% by weight based on the total solid content in the photosensitive layer. When the amount of these infrared absorbers to be incorporated falls below 0.01% by weight, the desired effect of improving sensitivity cannot be exerted. On the contrary, when the amount of these infrared absorbers to be incorporated exceeds 50% by weight, the uniformity of the photosensitive layer is lost, making it likely that the durability of the photosensitive layer can be deteriorated and the non-image area can be contaminated.

These dyes or pigments may be incorporated in the photosensitive layer coating solution so that they are incorporated in the photosensitive layer with other components. Alternatively, these dyes or pigments may be incorporated in layers other than photosensitive layer during the preparation of the lithographic printing plate precursor. These dyes or pigments maybe used singly or in admixture of two or more thereof . Other components:

The photosensitive layer of the lithographic printing plate precursor of the invention may further comprise various additives incorporated therein. For example, other onium salts, aromatic sulfone compounds, aromatic sulfonic acid ester compounds, polyfunctional amine compounds, etc. may be incorporated in the photosensitive layer to enhance the function of preventing the aqueous alkali-soluble polymer compound from being dissolved in the developer to advantage.

Examples of the aforementioned onium salts employable herein include diazonium salts, ammonium salts, phosphonium salts, iodonium salts, sulfonium salts, selenonium salts, and arsonium salts. Preferred examples of the onium salts employable herein include diazonium salts disclosed in S. I. Schlesinger, "Photogr. Sci. Eng.", 18, 387 (1974), T. S. Bal et al, "Polymer", 21, 423 (1980), and JP-A-5-158230, ammonium salts disclosed in US Patents 4,069,055 and 4,069,056, and JP-A-3-140140, phosphonium salts disclosed in D. C. Necker et al, "Macromolecules", 17, 2468 (1984), C. S. Wen et al, "Macromolecules", 17, 2468 (1984), C. S. Wen et al, "Teh, Proc. Conf. Rad. Curing", ASIA, page 478, Tokyo, Oct. 1988, and US Patents 4,069,055 and 4,069,056, iodonium salts disclosed in J. V. Crivello et al, "Macromorecules", 10 (6), 1307 (1977), "Chem. & Eng. News", Nov. 28, page 31 (1988), European Patent 104,143, US Patents 339,049 and 410,201, JP-A-2-150848, and JP-A-2-296514, sulfonium salts disclosed in J. V. Crivello et al, "Polymer J.", 17, 73 (1985), J. V. Crivello et al, "J. Org. Chem.", 43, 3055 (1978), W. R. Watt et al, "J. Polymer Sci.", Polymer Chem. Ed. , 22, 1789 (1984), J. V. Crivello et al, "Polymer Bull. ", 14, 279 (1985), J. V. Crivello et al, "Macromorecules", 14 (5), 1141 (1981), J. V. Crivello et al, "J. Polymer Sci.", Polymer Chem. Ed. , 17, 2877 (1979), European Patents 370, 693, 233, 567, 297, 943 and 297, 442, US Patents 4, 933, 377, 3, 902, 114, 410,201, 339,049, 4,760,013, 4,734,444 and 2,833,827, and German Patents 2, 904, 626, 3, 604, 580 and 3, 604, 581, selenonium salts disclosed in J. V. Crivello et al, "Macromorecules", 10 (6), 1307 (1977), and J. V. Crivello et al, "J. Polymer Sci.", Polymer Chem. Ed. , 17, 1047 (1979), and arsonium salts disclosed in C. S. Wen et al, "Teh, Proc. Conf. Rad. Curing ASIA", page 478, Tokyo, Oct 1988.

Examples of the counter ion of the aforementioned onium salt include tetrafluoroboric acid, hexafluorophosphoric acid, triisopropylnaphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3-chlorobenzenesulfonic acid, 3-bromobenzenesulfonic acid, 2-fluorocaprylnaphthalenesulfonic acid, dodecylbenzenesulfonic acid, 1-naphthol-5-sulfonic acid, 2-methoxy-4-hydroxy-5-benzoyl-benzenesulfonic acid, and paratoluenesulfonic acid. Particularly preferred among these counter ions are hexafluorophosphoric acid, and alkylaromatic sulfonic acid such as triisopropylnaphthalenesulfonic acid and 2,5-dimethylbenzenesulfonic acid.

The aforementioned onium salts are preferably incorporated in an amount of from 0.1 to 50% by weight, more preferably from 0.5 to 30% by weight, particularly from 1 to 10% by weight based on the total solid content of the material constituting the photosensitive layer.

For the purpose of further enhancing sensitivity, cyclic acid anhydrides, phenols and organic acids may be additionally used. Examples of the cyclic acid anhydride employable herein include phthalic anhydride, tetrahydrophthalic anhydride, hexahydrophthalic anhydride, 3,6-endoxy-4-tetrahydrophthalic anhydride, tetrachlorophthalic anhydride, maleic anhydride, chloromaleic anhydride, α-phenylmaleic anhydride, succinic anhydride and pyromellitic anhydride disclosed in US Patent 4, 115, 128. Examples of the phenols include bisphenol A, p-nitrophenol, p-ethoxyphenol, 2,4,4'-trihydroxybenzophenone, 2,3,4-trihydroxybenzophenone, 4-hydroxybenzophenone, 4,4',4"-trihydroxytriphenylmethane, and 4,4',3",4"-tetrahydroxy-3,5,3',5'-tetramethyltriphenylmeth ane. Examples of the organic acids include sulfonic acids, sulfinic acids, alkylsulfuric acids, phosphonic acids, phosphoric acid esters and carboxylic acids disclosed in JP-A-60-88942 and JP-A-2-96755. Specific examples of these organic acids include p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3, 4-dimethoxybenzoic acid, phthalic acid, terephthalic acid, 4-cyclohexene-1,2-dicarboxylicacid, erucicacid, lauricacid, n-undecanoic acid, and ascorbic acid. The proportion of the aforementioned cyclic acid anhydrides, phenols and organic acids in the photosensitive layer is preferably from 0.05 to 20% by weight, more preferably from 0.1 to 15% by weight, particularly from 0.1 to 10% by weight as calculated in terms of solid content.

The photosensitive layer of the lithographic printing plate precursor of the invention may comprise a nonionic surface active agent disclosed in JP-A-62-251740 and JP-A-3-208514 and an amphoteric surface active agent disclosed in JP-A-59-121044 and JP-A-4-13149 incorporated therein to increase the stability against the development conditions. Specific examples of the nonionic surface active agent include sorbitan tristearate, sorbitan monopalmitate, sorbitan trioleate, monoglyceride stearate, and polyoxyethylene nonyl phenyl ether. Specific examples of the amphoteric surface active agents include alkyl di(aminoethyl)glycine, alkyl polyaminoethyl glycine hydrochloride, 2-alkyl-N-carboxyethyl-N-hydroxyethylimidazolinium betain type surface active agent, and N-tetradecyl-N,N-betain type surface active agent (e.g., trade name "Amogen K", produced by DAIICHI INDUSTRIAL CO., LTD.). The proportion of the aforementioned nonionic surface active agents and amphoteric surface active agents in the total solid content in the photosensitive layer is preferably from 0. 05 to 15% by weight, more preferably from 0.1 to 5% by weight.

The photosensitive layer coating solution of the invention may comprise a surface active agent for improving coatability, e.g., fluorine-based surface active agent as disclosed in JP-A-62-170950 incorporated therein. The amount of the surface active agent to be incorporated in the coating solution is preferably from 0.01 to 1% by weight, more preferably from 0.05 to 0.5% by weight based on the total solid content in the photosensitive layer.

The photosensitive layer of the invention may comprise a printing-out agent for providing a visible image shortly after heating by exposure or a dye or pigment as an image colorant. Representative examples of the printing-out agent include a combination of a compound (photo-acid generator) which generates an acid when heated upon exposure and an organic dye capable of forming a salt. Specific examples of such a combination include a combination of o-naphthoquinonediazide-4-sulfonic acid halogenide and a salt-forming organic dye disclosed in JP-A-50-36209 and JP-A-53-8128, and a combination of a trihalomethyl compound and a salt-forming organic dye disclosed in JP-A-53-36223, JP-A-54-74728, JP-A-60-3626, JP-A-61-143748, JP-A-61-151644 and JP-A-63-58440. Examples of the trihalomethyl compound include oxazole-based compounds and triazine-based compounds. Both the two compounds have an excellent age stability and give a definite printed-out image.

As the image colorants there may be used dyes other than the aforementioned salt-forming organic dyes. Preferred examples of the dyes employable herein include oil-soluble dyes and basic dyes, including salt-forming organic dyes. Specific examples of these dyes include Oil Yellow #101, Oil Yellow #103, Oil Pink #312, Oil Green BG, Oil Blue BOS, Oil Blue #603, Oil Black BY, Oil Black BS, Oil Black T-505 (produced by Orient Chemical Industries, Ltd.), Victoria Pure Blue, Crystal Violet (CI42555), Methyl Violet (CI42535), Ethyl Violet, Rhodamine B (CI145170B), Malachite Green (CI42000), and Methylene Blue (CI52015). Dyes disclosed in JP-A-62-293247 are particularly preferred. These dyes may be incorporated in the photosensitive layer in an amount of from 0.01 to 10% by weight, preferably from 0.1 to 3% by weight based on the total solid content of the photosensitive layer.

If necessary, the photosensitive layer of the invention may comprise an epoxy compound, a vinyl ether, a phenol compound having hydroxymethyl group and a phenol compound having alkoxymethyl group disclosed in JP-A-8-276558, a crosslinkable compound having an alkali dissolution inhibiting action disclosed in JP-A-11-160860, etc. incorporated therein properly depending on the purpose.

The lithographic printing plate precursor of the invention can be produced by dissolving components of the photosensitive layer coating solution and the coating solutions for desired layers such as protective layer in solvents, and then spreading the solutions onto a proper support. As the coating solvent for the photosensitive layer there may be used those described above. For the protective layer, back coat layer, etc., known solvents may be properly selected depending on the components used.

As the support to be used in the lithographic printing plate precursor of the invention there may be used a dimensionally stable tabular material. Examples of such a tabular material employable herein include paper, paper laminated with a plastic (e.g., polyethylene, polypropylene, polystyrene), metal sheet (e.g., aluminum, zinc, copper), plastic film (e.g., cellulose diacetate, cellulose triacetate, cellulose propionate, cellulose butyrate, cellulose acetobutyrate, cellulose nitrate, polyethylene terephthalate, polyethylene, polystyrene, polypropylene, polycarbonate, polycarbonate, polyvinyl acetal), and paper or plastic film laminated with or vacuum-plated with such a metal.

As the support to be used in the lithographic printing plate precursor of the invention there is preferably used a polyester film or aluminum sheet. Particularly preferred among these support materials is aluminum sheet, which is excellent in dimensional stability and relatively inexpensive. A preferred example of aluminum sheet is a pure aluminum sheet or an alloy sheet mainly composed of aluminum containing a slight amount of foreign elements. A further example of aluminum sheet is a plastic film laminated with or vacuum-plated with aluminum. Examples of the foreign elements to be incorporated in the aluminum alloy include silicon, iron, manganese, copper, magnesium, chromium, zinc, bismuth, nickel, and titanium. The content of foreign elements in the alloy is 10% by weight at maximum. A particularly preferred aluminum in the invention is pure aluminum. However, since pure aluminum can be difficultly produced from the standpoint of refining technique, aluminummay contain a slight amount of foreign elements. Thus, the composition of the aluminum sheet to be used in the invention is not specifically limited. Any known general-purpose aluminum sheet may be properly used. The thickness of the aluminum sheet to be used in the invention is from about 0.1 mm to 0.6 mm, preferably f rom about 0.15 mm to 0.4 mm, particularly from about 0.2 mm to 0.3 mm.

Prior to roughening the aluminum sheet, the aluminum sheet is subjected to treatment for removing the rolling oil from the surface thereof, e.g., degreasing with a surface active agent, organic solvent or alkaline aqueous solution. The roughening of the surface of the aluminum sheet may be accomplished by various methods such as method involving the mechanical roughening of aluminum sheet, method involving the electrochemical dissolution and roughening of aluminum sheet and method involving the chemical selective dissolution of aluminum sheet. As the mechanical method there may be used any known method such as ball polishing, brushing, blasting method and buffing. As the electrochemical roughening method there may be used a method using alternating or direct current in a hydrochloric acid or nitric acid electrolyte. Alternatively, a method involving the combined use of alternating current and direct current may be used as disclosed in JP-A-54-63902. The aluminum sheet thus roughened is then subjected to treatment with an alkali and neutralization as necessary. The aluminum sheet thus treated is then optionally subjected to anodization for enhancing the water retention and abrasion resistance of the surface of the aluminum sheet. As the electrolyte to be used in the anodization of aluminum sheet there may be used any electrolyte for forming a porous oxide film. In general, sulfuric acid, phosphoric acid, oxalic acid, chromic acid or mixture thereof may be used. The concentration of the electrolyte may be properly predetermined by the kind of the electrolyte.

The anodization conditions vary with the kind of the electrolyte used and thus cannot be unequivocally predetermined. In practice, however, it is preferred that the concentration of the electrolyte be from 1 to 80% by weight, the temperature of the electrolyte be from 5°C to 70°C, the current density be from 5 to 60 A/dm², the electrolyte voltage be from 1 to 100 V and the electrolysis time be from 10 seconds to 5 minutes. When the amount of the anodized film falls below 1.0 g/m², the resulting lithographic printing plate exhibits an insufficient press life and is subject to scratching on the non-image area on the lithographic printing plate and hence so-called "scratch stain" involving the attachment of ink to scratches during printing. An example of the hydrophilicization treatment to be used in the invention is an alkaline metal silicate (e.g., aqueous solution of sodium silicate) method as disclosed in US Patents 2, 714, 066, 3, 181, 461, 3, 280, 734 and 3, 902, 734. In accordance with this method, the support is subjected to dipping in an aqueous solution of sodium silicate or electrolysis. Besides these methods, a method involving the treatment with potassium fluorozirconate disclosed in JP-B-36-22063 and a method involving the treatment with a polyvinylphosphonic acid disclosed in US Patents 3, 276, 868, 4, 153, 461 and 4, 689, 272 may be used.

The lithographic printing plate precursor of the invention comprises the aforementioned positive-working photosensitive layer provided on the support. If necessary, an undercoat layer may be provided between the support and the positive-working photosensitive layer. As the undercoat layer components there may be used various organic compounds. These organic compounds may be selected from the group consisting of carboxymethyl cellulose, dextrin, gum arabic, phosphonic acids having amino group such as 2-aminoethylphosponic acid, organic phosphonic acids which may have substituents such as phenylphosphonic acid, naphthylphosphonic acid, alkylphosphonic acid, glycerophosphonic acid, methylenediphosphonic acid and ethylenediphosphonic acid, organic phosphoric acids which may have substituents such as phenylphosphoric acid, naphthylphosphoric acid, alkylphosphoric acid and glycerophosphoric acid, organic phosphinic acids which may have substituents such as phenylphosphinic acid, naphthylphosphinic acid, alkylphosphinic acid and glycerophosphinic acid, amino acids such as glycine and β-alanine, and hydrochloride of amine having hydroxyl group such as triethanolamine hydrochloride.

Further preferred examples of the undercoat layer components employable herein include polymer compounds comprising a constituent having an acid group and a constituent having an onium group. These polymer compounds are polymers preferably having a vinyl-based polymer such as acrylic resin, methacrylic resin and polystyrene or urethane resin, polyester or polyamide as a main chain structure. More preferably, the main chain structure of these polymer compounds is a vinyl-based polymer such as acrylic resin, methacrylic resin and polystyrene. The aforementioned acid group is preferably an acid group having an acid dissociation index (pKa) of not greater than 7, more preferably -COOH, -SO₃H, -OSO₃H, -PO₃H₂, -OPO₃H₂, -CONHSO₂ or -SO₂NHSO₂-, particularly-COOH. The aforementioned onium group is preferably an onium group comprising atoms of the group V or VI, more preferably an onium group comprising nitrogen atom, phosphorus atom or sulfur atom, particularly an onium group comprising nitrogen atom. Specific examples of these compounds include those disclosed in JP-A-200-241962.

The organic undercoat layer may be provided by the following method. In other words, the organic undercoat layer may be provided by a method which comprises spreading a solution of the aforementioned organic compound in water, an organic solvent such as methanol, ethanol and methyl ethyl ketone or mixture thereof onto an aluminum sheet, and then drying the coated material or a method which comprises dipping an aluminum sheet in a solution of the aforementioned organic compound in water, an organic solvent such as methanol, ethanol and methyl ethyl ketone or mixture thereof to allow the aforementioned compound to be adsorbed by the aluminum sheet, washing the aluminum sheet with water or the like, and then drying the aluminum sheet. In accordance with the former method, a solution containing the aforementioned organic compound in a concentration of from 0.005 to 10% by weight can be spread onto the aluminum sheet. In accordance with the latter method, the solution concentration is from 0.01 to 20% by weight, preferably from 0.05 to 5% by weight, the dipping temperature is from 20°C to 90°C, preferably from 25°C to 50°C, and the dipping time is from 0.1 seconds to 20 minutes, preferably from 2 seconds to 1 minute. The solution to be used in this method may be adjusted to a pH value of from 1 to 12 with a basic material such as ammonia, triethylamine and potassium hydroxide or an acidic material such as hydrochloric acid and phosphoric acid. In order to improve the tone reproducibility of the lithographic printing plate precursor, a yellow dye may be added.

The spread of the organic undercoat layer is preferably from 2 to 200 mg/m², more preferably from 5 to 100 mg/m². When the spread of the organic undercoat layer falls below 2 mg/m², the resulting lithographic printing plate precursor has an insufficient press life. On the contrary, when the spread of the organic undercoat layer exceeds 200 mg/m², the same trouble can occur.

### Plate making/printing:

The lithographic printing plate precursor thus prepared is normally then subjected to imagewise exposure and development. Examples of the active ray source to be used in imagewise exposure include solid laser and semiconductor laser which emit infrared rays having a wavelength of from 760 nm to 1,200 nm. In the invention, a light source which emits light having a wavelength ranging from near infrared to infrared is preferred. Particularly preferred are solid laser and semiconductor laser.

Any unnecessary image areas (e.g., mark of edge of original film) on the lithographic printing plate which has thus been imagewise exposed, developed, washed with water, rinsed and/or gummed are then deleted. This deletion is preferably accomplished by a method as disclosed in JP-B-2-13293 which comprises spreading an eraser onto the unnecessary image areas, allowing the coated areas to stand for a predetermined period of time, and then washing the areas with water. Alternatively, a method as disclosed in JP-A-59-174842 may be used which comprises irradiating the unnecessary image areas with active rays introduced through an optical fiber, and then developing the lithographic printing plate precursor.

The lithographic printing plate precursor thus obtained may be optionally coated with a desensitizing gum before printing. In order to provide a lithographic printing plate having a higher press life, the lithographic printing plate may be subjected to burning. In the case where the lithographic printing plate is subjected to burning, it is preferred that the lithographic printing plate be processed with an affinitizer as disclosed in JP-B-61-2518, JP-B-55-28062, JP-A-62-31859 and JP-A-61-159655 prior to burning. Examples of the processing method include a method which comprises spreading such an affinitizer onto the lithographic printing plate with a sponge or degreased cotton, a method which comprises dipping the printing plate in a bath filled with the affinitizer, and a method which comprises spreading an affinitizer onto the printing plate using an automatic coater. By uniformalizing the spread using a squeegee or squeegee roller, better results can be provided.

The spread of the affinitizer is normally from 0.03 to 0.8 g/m² (as calculated in terms of dried amount). The lithographic printing plate thus coated with an affinitizer is optionally dried, and then heated to a high temperature using a burning processor (e.g., Type BP-1300 burning processor, commercially available from Fuji Photo Film Co., Ltd.) or the like. The heating temperature and time depend on the kind of the components forming image but are preferably from 180°C to 300°C and from 1 to 20 minutes, respectively.

The lithographic printing plate which has thus been subjected to burning may be optionally subjected to processing which has heretofore been effected such as rinsing and gumming. However, in the case where an affinitizer containing a water-soluble polymer compound or the like is used, a so-called desensitizing such as gumming can be omitted. The lithographic printing plate thus processed is then mounted on an offset printing machine to effect printing on a large number of sheets of paper.

### Examples

The invention will be further described in the following examples, but the invention should not be construed as being limited thereto.

### (Preparation of substrate A)

An aluminum sheet having a thickness of 0.3 mm (material: 1050) was degreased with trichloroethylene, grained on the surface thereof with a nylon brush and an aqueous suspension of 400-mesh pumice, and then thoroughly washed with water. The aluminum sheet thus grained was dipped in a 45°C 25% aqueous solution of sodium hydroxide for 9 seconds, washed with water, dipped in a 20% nitric acid for 20 seconds, and then washed with water. The etched amount of the grained surface of the aluminum sheet was about 3 g/m². The aluminum sheet thus processed was anodized in a 7% sulfuric acid as an electrolyte with dc current at a current density of 15 A/dm2 to form an anodized film having a density of 3 g/m², washed with water, and then dried to obtain a substrate A.

### (Preparation of substrate B)

The substrate A was coated with the following undercoating solution, and then dried at a temperature of 90°C for 1 minute to obtain a substrate B. The spread of the coat was 10 mg/m² as calculated in terms of dried amount.

### <Composition of undercoating solution>

| | |
|---|---|
| β-Alanine | 0.5 g |
| Methanol | 95 g |
| Water | 5 g |

### (Preparation of substrate C)

The substrate A was processed with a 2.5% aqueous solution of sodium silicate at a temperature of 30°C for 10 seconds, coated with the following undercoating solution 2, and then dried at a temperature of 80°C for 15 seconds to obtain a substrate C. The spread of the coat was 15 mg/m² as calculated in terms of dried amount.

### <Composition of undercoating solution 2>

| | |
|---|---|
| Polymer compound shown below | 0.3 g |
| Methanol | 100 g |
| Water | 1 g |

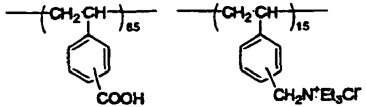

### (Composition ratio represents molar ratio)

### <Composition of photosensitive layer coating solution 1>

* m, p-Cresol novolak 1 g
   (m/p ratio: 6/4; weight-average molecular
   weight: 3,500; unreacted cresol content: 0.5%
   by weight)
   (aqueous alkali-soluble polymer compound)
* Infrared absorber (cyanine dye A shown below) 0.2 g
* Dye obtained by converting counter anion of Victoria Pure Blue BOH to 1-naphthalenesulfonic acid anion 0.02 g
* Fluorine-based surface active agent 0.05 g
   (Megafac F-177, produced by DAINIPPON INK AND CHEMICALS, INCORPORATED)
* Solvent (methyl ethyl ketone) 18 g

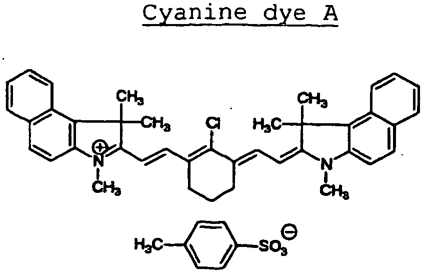

### <Composition of photosensitive layer coating solution 2>

* m, p-Cresol novolak 0.3 g
   (m/p ratio: 6/4; weight-average molecular
   weight: 3,500; unreacted cresol content: 0.5%
   by weight)
   (aqueous alkali-soluble polymer compound)
* Copolymer 1 described in examples of JP-A-11-348443 0.7 g
* Infrared absorber (cyanine dye A shown above) 0.15 g
* p-Toluenesulfonic acid 0.002 g
* Dye obtained by converting counter anion of Victoria Pure Blue BOH to 1-naphthalenesulfonic acid anion 0.02 g
* Fluorine-based surface active agent 0.05 g
   (Megafac F-177, produced by DAINIPPON INK AND CHEMICALS, INCORPORATED)
* γ-Butyrolactone 8 g
* Methyl ethyl ketone 8 g
* 1-Methoxy-2-propanol 4 g

### Copolymer 1 (Mw: 5.3 x 10⁴)

### (Synthesis method: see JP-A-11-348443)

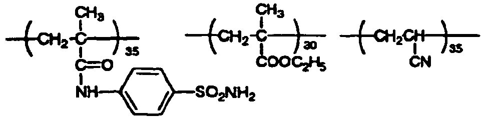

### Examples 1 to 8 and Comparative Examples 1 to 3

### (Preparation of lithographic printing plate)

The substrates B and C obtained in the aforementioned preparation examples were each coated with the aforementioned photosensitive layer coating solutions 1 and 2 in a combination set forth in Table 1 to prepare lithographic printing plates.

The photosensitive layer coating solution 1, if used, was spread in an amount of 1.5 g/m² as calculated in terms of dried amount. The coated material was then heated and dried at a temperature of 100°C and ordinary pressure in an oven with an exhaust duct for 60 seconds to obtain a lithographic printing plate.

The photosensitive layer coating solution 2, if used, was spread in an amount of 1.3 g/m² as calculated in terms of dried amount. The coated material was then heated and dried at a temperature of 150°C and ordinary pressure in the same oven as used above for 110 seconds to obtain a lithographic printing plate.

### (Preparation of alkaline developer A containing nonreducing sugar)

To a 5.0% aqueous solution of a potassium salt comprising D-sorbitol/potassium oxide K₂O comprising a nonreducing sugar and a base in combination was added the following compound in a proportion of 1.5 g/l to prepare an alkaline developer A.

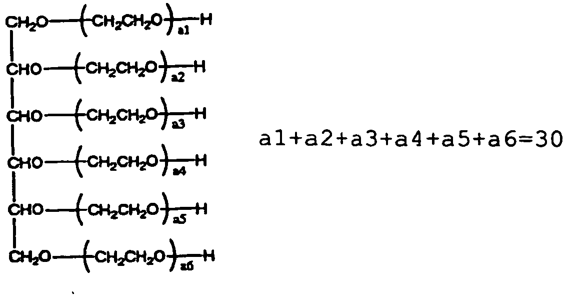

### (Preparation of alkaline developer B containing SiO₂)

To a 4.0% aqueous solution of potassium silicate having a SiO₂ (silicon oxide) /K₂O (potassium oxide) mixing ratio of 1.1 was added Compound A in a proportion of 1. 0 g/l to prepare an alkaline developer B.

### (Evaluation of plate)

The lithographic printing plates thus obtained were each subjected to exposure at a drum rotary speed of 150 rpm and an output of 10 W using a trend setter 3244 produced by CreoScitex Inc. , and then developed using an automatic developing machine (PS Processor LP-940H, produced by Fuji Photo Film Co., Ltd.) . During this procedure, the first tank and the subsequent second tank in the automatic developing machine were filled with the developer prepared according to the aforementioned method and the following aqueous solution, respectively, in a combination set forth in Table 1. The third tank was filled with a Type FP-2W rinsing solution (diluted with water at a ratio of 1 : 1) (produced by Fuji Photo Film Co., Ltd.).

The development was effected at a developer temperature of 30°C, an aqueous solution temperature of 25°C (supplied sprayed onto the surface of the printing plate) and a rinsing solution temperature of 25°C for 25 seconds. The surface of the printing plate thus processed was then observed to count the number of scum particles attached thereto. After processed over 100 m², the printing plate was observed for the occurrence of precipitation at the rinsed area to evaluate the effect of processing with the aqueous solution. Further, the reproducibility of fine lines having a width of 10 µm on the printing plate was observed by a 5xmagnifier to evaluate the image reproducibility. The results of evaluation are set forth in Table 1.

### (Aqueous solution 1)

To tap water was added a Type LH-DP developer (1 : 8) produced by Fuji Photo Film Co., Ltd. in an amount of 0.1% (by volume) to obtain an aqueous solution 1. The aqueous solution 1 had a pH value of 10.1 at 25°C.

### (Aqueous solution 2)

To tap water was added a Type LH-DP developer (1 : 8) produced by Fuji Photo Film Co., Ltd. in an amount of 0.3% (by volume) to obtain an aqueous solution 2. The aqueous solution 2 had a pH value of 10.8 at 25°C.

### (Aqueous solution 3)

To tap water was added a Type LH-DP developer (1 : 8) produced by Fuji Photo Film Co., Ltd. in an amount of 0.02% (by volume) to obtain an aqueous solution 3. The aqueous solution 3 had a pH value of 9.3 at 25°C.

### (Aqueous solution 4)

To tap water was added a Type LH-DP developer (1 : 8) produced by Fuji Photo Film Co., Ltd. in an amount of 3% (by volume) to obtain an aqueous solution 4. The aqueous solution 4 had a pH value of 12.2 at 25°C.

### (Aqueous solution 5)

To tap water was added a Type LH-DP developer (1 : 8) produced by Fuji Photo Film Co., Ltd. in an amount of 0.1% (by volume) to obtain an aqueous solution 5. The aqueous solution 5 had a pH value of 9.8 at 25°C.

### (Aqueous solution 6)

Tap water was used unprocessed as an aqueous solution 6. The aqueous solution 6 had a pH value of 6.8 at 25°C.

**Table 1**

| Example No. | Substrate | Photosensitive layer | First tank | Second tank | Development scum | | Image reproducibility |
|---|---|---|---|---|---|---|---|
| | | | Developer | Aqueous solution | Precipitation on rinsed area | Number of scum on plate | |
| Example 1 | B | 1 | A | 1 | None | 1 | Good |
| Example 2 | B | 1 | A | 2 | None | 0 | Good |
| Example 3 | B | 1 | A | 3 | None | 2 | Good |
| Example 4 | B | 1 | A | 5 | None | 1 | Good |
| Example 5 | B | 2 | A | 1 | None | 3 | Good |
| Example 6 | C | 1 | A | 1 | None | 1 | Good |
| Example 7 | C | 2 | A | 1 | None | 2 | Good |
| Example 8 | B | 1 | B | 1 | None | 2 | Good |
| Comparative Example 1 | B | 1 | A | 6 | None | 7 | Break in 10 µm fine line |
| Comparative Example 2 | B | 1 | A | 4 | Observed | 25 | Good |
| Comparative Example 3 | B | 1 | B | 4 | Observed | 22 | Good |

As can be seen in the results of Table 1, the process for the development of lithographic printing plate involving a step of processing with an aqueous solution having a pH value of from 9 to 11 shortly after development step causes no occurrence of development scum and provides a good image reproducibility.

In accordance with the invention, a development process can be provided which can inhibit the occurrence of development scum during the development of a lithographic printing plate precursor having an infrared laser beam-recording photosensitive layer containing an infrared absorber and a novolak resin.

This application is based on Japanese patent application JP 2002-286111, filed on September 30, 2002, the entire content of which is hereby incorporated by reference, the same as if set forth at length.

## Claims

1. A process for developing a lithographic printing plate comprising the steps of:
exposing with infrared rays a lithographic printing plate precursor comprising a photosensitive layer capable of recording with an infrared laser beam, the photosensitive layer comprising an infrared absorber and a novolak resin;
developing the exposed lithographic printing plate precursor with a developer having a pH value of 12.5 to 14.0; and
processing the developed lithographic printing plate precursor with an aqueous solution having a pH value of from 9 to 11 directly after the development step.

2. A process according to Claim 1, wherein the developer contains an alkali silicate.

3. A process according to Claim 1, wherein the developer contains a non-reducing sugar and a base.

## Patentansprüche

1. Verfahren zum Entwickeln einer Lithographiedruckplatte, umfassend die Schritte:
Belichten mit Infrarotstrahlen eines Lithographiedruckplattenvorläufers, umfassend eine fotoempfindliche Schicht, die zur Aufzeichnung mit einem Infrarotlaserstrahl befähigt ist, wobei die fotoempfindliche Schicht einen Infrarotabsorber und ein Novolak-Harz umfasst;
Entwickeln des belichteten Lithographiedruckplattenvorläufers mit einem Entwickler, der einen pH-Wert von 12,5 bis 14,0 aufweist; und
Verarbeiten des entwickelten Lithographiedruckplattenvorläufers mit einer wässrigen Lösung, die einen pH-Wert von 9 bis 11 aufweist, direkt nach dem Entwicklungsschritt.

2. Verfahren gemäß Anspruch 1, worin der Entwickler ein Alkalisilikat enthält.

3. Verfahren gemäß Anspruch 1, worin der Entwickler einen nichtreduzierenden Zucker und eine Base enthält.

## Revendications

1. Processus pour développer une plaque d'impression lithographique comprenant les étapes de :
exposition par des rayons infrarouges d'un précurseur de plaque d'impression lithographique comprenant une couche photosensible susceptible d'enregistrement par un faisceau laser infrarouge, la couche photosensible comprenant un absorbeur d'infrarouge et une novalaque ;
développement du précurseur de plaque d'impression lithographique exposé avec un développeur ayant une valeur de pH de 12,5 à 14,0 ; et
traitement du précurseur de plaque d'impression lithographique développé avec une solution aqueuse ayant une valeur de pH de 9 à 11 directement après l'étape de développement.

2. Processus selon la revendication 1, dans lequel le développeur contient un silicate alcalin.

3. Processus selon la revendication 1, dans lequel le développeur contient un sucre non réducteur et une base.
